# EUROPEAN PATENT APPLICATION

(11) **EP 4 418 542 A1**
(43) Date of publication of application: **21.08.2024**
(21) Application number: 21961982.2
(22) Date of filing: 30.10.2021
(51) Int. Cl.: H04B 1/04, H04B 7/06, H01L 23/66

(54) **COMMUNICATION CHIP, COMMUNICATION MODULE, COMMUNICATION SYSTEM AND BASE STATION**

(71) Applicant: Huawei Technologies Co., Ltd., Shenzhen, Guangdong 518129 (CN)
(72) Inventor: DING, Wenqi, Shenzhen, Guangdong 518129 (CN); ZHOU, Qian, Shenzhen, Guangdong 518129 (CN); TANG, Haizheng, Shenzhen, Guangdong 518129 (CN); CUI, Changyun, Shenzhen, Guangdong 518129 (CN); LIANG, Le, Shenzhen, Guangdong 518129 (CN); ZHENG, Wenquan, Shenzhen, Guangdong 518129 (CN); ZHOU, Xiaomin, Shenzhen, Guangdong 518129 (CN)
(74) Representative: Pfenning, Meinig & Partner mbB
(86) International application number: PCT/CN2021/127779
(87) International publication number: WO 2023/070631

(57) **Abstract**

Embodiments of this application disclose a communication chip, a communication module, a communication system, and a base station. The communication chip specifically includes a frequency mixer, a power division module, and a switch module. The frequency mixer is connected to a first interface, and the frequency mixer is configured to perform frequency conversion on a first input signal received by the first interface or a first output signal that needs to be sent by the first interface. The power division module is connected to a second interface, and the power division module is configured to perform combination on a second input signal received by the second interface or perform power division on a second output signal that needs to be sent by the second interface. The switch module is connected to a third interface. The third interface is configured to receive a third input signal or send a third output signal. The switch module is configured to control the second interface to form a closed circuit with the third interface through the power division module, or to form a closed circuit with the first interface through the power division module and the frequency mixer, so that the communication chip can be used as a driver chip or a frequency mixer chip in series at the same time, thereby reducing a loss of a power divider at low costs.

## Description

### TECHNICAL FIELD

Embodiments of this application relate to the communications field, and in particular, to a communication chip, a communication module, a communication system, and a base station.

### BACKGROUND

A coverage bottleneck exists in a current fifth-generation mobile communication technology (5th generation mobile communication technology, 5G) millimeter wave base station, and increasing an output power of a base station is an urgent requirement of the current highfrequency millimeter wave system.

However, in a millimeter wave analog beamforming (analog beamforming, ABF) system and an antenna in printed circuit board (antenna in PCB, AIP) system, an AIP in the millimeter wave system may be implemented by using a beamforming chip (beamforming IC, BFIC). An effective manner of improving an equivalent isotropically radiated power (equivalent isotropically radiated power, EIRP) is to expand an antenna array. As the antenna array expands, a quantity of front-end BFIC chips increases. To ensure that an output power of a power amplifier (power amplifier, PA) in the BFIC chip remains unchanged to obtain an entire gain brought by array expansion, a loss caused by passive power division between the BFIC chip and a frequency mixer chip (up-down convert, UDC) increases continuously. An output power of the UDC increases with the loss of a power divider. As a result, the output power of the UDC is linearly restricted, the system power needs to be rolled back, and the gain brought by antenna array expansion cannot be obtained. Adding a driver chip (driver IC, DRV) between the UDC and the BFIC may resolve the foregoing problem. The DRV can reduce the loss of the power divider.

However, frequencies at two ends of the current UDC are not equal, and the UDC cannot be directly used in series. As a result, the UDC does not have a self-cascading capability. The DRV needs to be re-customized based on different UDCs, and customization costs are high. Consequently, the gain brought by antenna array expansion is difficult to obtain.

### SUMMARY

Embodiments of this application provide a communication chip, a communication module, a communication system, and a base station, to obtain a gain brought by antenna array expansion at low costs.

A first aspect of this application provides a communication chip, including a frequency mixer, a power division module, and a switch module. The frequency mixer is connected to a first interface, and the frequency mixer is configured to perform frequency conversion on a first input signal received by the first interface or a first output signal that needs to be sent by the first interface. The power division module is connected to a second interface, and the power division module is configured to perform combination on a second input signal received by the second interface or perform power division on a second output signal that needs to be sent by the second interface. The switch module is connected to a third interface. The third interface is configured to receive a third input signal or send a third output signal. The switch module is configured to control the second interface to form a closed circuit with the third interface through the power division module, or to form a closed circuit with the first interface through the power division module and the frequency mixer.

The frequency mixer in this application is also referred to as an up-down converter chip, and may be of an active or passive frequency mixer structure. The frequency mixer is configured to perform frequency relocation on a signal, and supports a 2/3/4 or N standby frequency function. The power division module may specifically be an active power division network, including active power division functions with 2 equal power division ways and with N power division ways, where N is greater than 2. The first interface, the second interface, and the third interface may specifically be pins.

According to the first aspect, the communication chip includes the frequency mixer, the power division module, and the switch module. The frequency mixer is connected to the first interface, the power division module is connected to the second interface, and the switch module is connected to the third interface. The switch module is configured to control the second interface to form a closed circuit with the third interface through the power division module, so that the communication chip can be used as a driver chip, or to form a closed circuit with the first interface through the power division module and the frequency mixer, so that the communication chip can be used as a frequency mixer chip. In other words, the communication chip has functions of both the frequency mixer chip and the driver chip, and can be separately used as the frequency mixer chip and the driver chip in series at the same time to reduce a loss of a power divider, thereby obtaining the gain brought by antenna array expansion at low costs.

In a possible implementation of the first aspect, the communication chip further includes a first signal switch and a second signal switch. The first signal switch is disposed between the frequency mixer and the first interface, and the second signal switch is disposed between the frequency mixer and the switch module. The first signal switch and the second signal switch are configured to determine that the first interface is to receive the first input signal or send the first output signal.

In this possible implementation, the signal switches are disposed to determine that the communication chip is to receive or send the signal, to improve feasibility of the solution.

In a possible implementation of the first aspect, the communication chip further includes a first amplifier. The first amplifier is disposed between the first signal switch and the first interface. The first amplifier is configured to amplify the first input signal or the first output signal.

In this possible implementation, the amplifier is disposed in the communication chip to amplify the signal, to reduce a signal loss.

In a possible implementation of the first aspect, the communication chip further includes a third signal switch. The third signal switch is disposed between the third interface and the switch module. The third signal switch is configured to determine that the third interface is to receive the third input signal or send the third output signal.

In this possible implementation, the signal switch is disposed to determine that the communication chip is to receive or send the signal, to improve feasibility of the solution.

In a possible implementation of the first aspect, the communication chip further includes a fourth signal switch. The fourth signal switch is disposed between the second interface and the power division module. The fourth signal switch is configured to determine that the second interface is to receive the second input signal or send the second output signal.

In this possible implementation, the signal switch is disposed to determine that the communication chip is to receive or send the signal, to improve feasibility of the solution.

In a possible implementation of the first aspect, the communication chip further includes a second amplifier. The second amplifier is disposed between the fourth signal switch and the power division module, and the second amplifier is configured to amplify the second input signal or the second output signal.

In this possible implementation,

In a possible implementation of the first aspect, the communication chip further includes a third amplifier disposed between the power division module and the switch module. The third amplifier is configured to amplify the first input signal, the first output signal, the second input signal, the second output signal, the third input signal, or the third output signal.

In this possible implementation, the amplifier is disposed in the communication chip to amplify the signal, to reduce the signal loss.

In a possible implementation of the first aspect, the communication chip further includes an attenuator disposed adjacent to the first amplifier, the second amplifier, or the third amplifier.

In this possible implementation, the attenuator is disposed in the communication chip, so that a size of a signal in a circuit can be adjusted, and impedance matching can be improved.

In a possible implementation of the first aspect, the switch module includes a first channel switch and a second channel switch. The first channel switch and the second channel switch are configured to control the second interface to form a closed circuit with the third interface through the power division module, or to form a closed circuit with the first interface through the power division module and the frequency mixer.

In this possible implementation, a function of the communication chip is specifically determined by disposing the first channel switch and the second channel switch, to improve feasibility of the solution.

In a possible implementation of the first aspect, the switch module or the third signal switch is a power divider.

In this possible implementation, the power divider is configured to implement a function of the switch module or the third signal switch, to improve feasibility of the solution.

A second aspect of this application provides a communication module. The communication module includes at least two communication chips according to the first aspect or any possible implementation of the first aspect. The switch modules of the at least two communication chips control the second interface to form different closed circuits.

In a possible implementation of the second aspect, a filter is disposed between the at least two communication chips.

In this possible implementation, the filter is disposed between the two communication chips, so that a frequency in a specific frequency band or a frequency outside the frequency band in the circuit can be effectively filtered out, to obtain a signal of a specific frequency.

A third aspect of this application provides a communication system. The communication system includes a digital processing unit, the communication module in the second aspect or any possible implementation of the second aspect, a multi-way power divider, a beamforming chip, and an antenna array that are sequentially connected.

In a possible implementation of the third aspect, a filter is disposed between the communication module and the beamforming chip.

In this possible implementation, the filter is disposed between the communication module and the beamforming chip, so that a frequency in a specific frequency band or a frequency outside the frequency band in the circuit can be effectively filtered out, to obtain a signal of a specific frequency.

In a possible implementation of the third aspect, the communication system is an active antenna unit.

In this possible implementation, the communication system may be used as the active antenna unit, to improve feasibility of the solution.

A fourth aspect of this application provides a base station. The base station includes the communication system in the third aspect or any possible implementation of the third aspect.

In an embodiment of this application, the communication chip includes the frequency mixer, the power division module, and the switch module. The frequency mixer is connected to the first interface, the power division module is connected to the second interface, and the switch module is connected to the third interface. The switch module is configured to control the second interface to form a closed circuit with the third interface through the power division module, so that the communication chip can be used as a driver chip, or to form a closed circuit with the first interface through the power division module and the frequency mixer, so that the communication chip can be used as a frequency mixer chip. In other words, the communication chip has functions of both the frequency mixer chip and the driver chip, and can be separately used as the frequency mixer chip and the driver chip in series at the same time to reduce the loss of the power divider, thereby obtaining the gain brought by antenna array expansion at low costs.

### BRIEF DESCRIPTION OF DRAWINGS

FIG. 1 is a schematic diagram of a framework of a base station;
FIG. 2 is a schematic diagram of an embodiment of a communication chip according to an embodiment of this application;
FIG. 3 is a schematic diagram of another embodiment of a communication chip according to an embodiment of this application;
FIG. 4 is a schematic diagram of another embodiment of a communication chip according to an embodiment of this application;
FIG. 5 is a schematic diagram of another embodiment of a communication chip according to an embodiment of this application;
FIG. 6 is a schematic diagram of an embodiment of a communication module according to an embodiment of this application;
FIG. 7 is a schematic diagram of an embodiment of a communication system according to an embodiment of this application; and
FIG. 8 is a schematic diagram of an embodiment of a base station according to an embodiment of this application.

### DESCRIPTION OF EMBODIMENTS

The following describes embodiments of this application with reference to the accompanying drawings. It is clear that the described embodiments are merely some rather than all embodiments of this application. A person of ordinary skill in the art may know that with technical development and emergence of a new scenario, the technical solutions provided in embodiments of this application are also applicable to a similar technical problem.

In the specification, claims, and accompanying drawings of this application, the terms "first", "second", and the like are intended to distinguish between similar objects but do not necessarily indicate a specific order or sequence. It should be understood that data termed in such a way are interchangeable in proper circumstances so that embodiments of the present invention described herein can be implemented in orders other than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

Embodiments of this application provide a communication chip, a communication module, a communication system, and a base station, to obtain a gain brought by antenna array expansion at low costs. Details are separately described below.

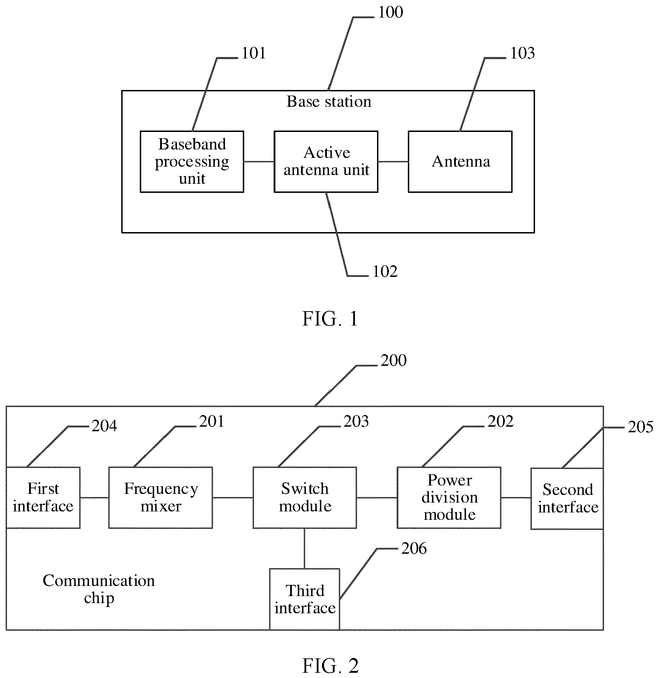

In a mobile communication system, for example, in a mobile communication system of a fifth generation mobile communication technology (5th generation mobile communication technology, 5G), a base station and user equipment are usually included. Refer to FIG. 1. On a base station side, a base station 100 may include a baseband processing unit 101, an active antenna unit (active antenna unit, AAU) 102, and an antenna 103. The baseband processing unit 101 is generally a building baseband unit (building baseband unit, BBU). The active antenna unit 102 includes a radio frequency unit and an antenna that are coupled together. A frequency mixer chip (up-down convert, UDC) and a driver chip (driver IC, DRV) may be disposed in the active antenna unit 102.

The following describes a communication chip 200 in this embodiment of this application with reference to the foregoing descriptions of the base station. Refer to FIG. 2. An embodiment of the communication chip 200 in this embodiment of this application includes a frequency mixer 201, a power division module 202, and a switch module 203.

The frequency mixer 201 is connected to a first interface 204, and the frequency mixer 201 is configured to perform frequency conversion on a first input signal received by the first interface 204 or a first output signal that needs to be sent by the first interface 204. The power division module 202 is connected to a second interface 205, and the power division module 202 is configured to perform combination on a second input signal received by the second interface 205 or perform power division on a second output signal that needs to be sent by the second interface 205. The switch module 203 is connected to a third interface 206. The third interface 206 is configured to receive a third input signal or send a third output signal. The switch module 203 is configured to control the second interface 205 to form a closed circuit with the third interface 206 through the power division module 202, or to form a closed circuit with the first interface 204 through the power division module 202 and the frequency mixer 201.

Specifically, the frequency mixer 201 is also referred to as an up-down converter chip, and may be of an active or passive frequency mixer structure. The frequency mixer 201 is configured to perform frequency relocation on a signal, and supports a 2/3/4 or N standby frequency function. The power division module 202 may specifically be an active power division network, including active power division functions with 2 equal power division ways and with N power division ways, where N is greater than 2. The first interface 204, the second interface 205, and the third interface 206 may specifically be pins.

The communication chip 200 may be used as a frequency mixer chip or a driver chip. The following separately provides descriptions.

### 1. The communication chip 200 is used as a frequency mixer chip.

In this case, in the communication chip 200, the switch module 203 controls the second interface 205 to form a closed circuit with the first interface 204 through the power division module 202 and the frequency mixer 201. In other words, the first interface 204, the frequency mixer 201, the switch module 203, the power division module 202, and the second interface 205 form a closed circuit, and the switch module 203 is disconnected from the third interface 206.

When the first interface 204 receives the first input signal, the frequency mixer 201 performs frequency conversion on the first input signal received by the first interface 204, and specifically, may up-convert an intermediate frequency signal to a microwave frequency to obtain the second output signal that needs to be sent by the second interface 205. The power division module 202 performs power division on the second output signal, and outputs the second output signal through the second interface 205. In this way, a function of the frequency mixer chip in the AAU when the base station transmits a signal can be implemented.

When the first interface 204 needs to send the first output signal, the second input signal is input to a power divider through the second interface 205. The power divider performs combination on the second input signal to obtain the first output signal that needs to be sent by the first interface 204. The frequency mixer 201 performs frequency conversion on the first output signal, and specifically, may down-convert the microwave signal to the intermediate frequency signal, and outputs the intermediate frequency signal through the first interface 204. In this way, a function of the frequency mixer chip in the AAU when the base station receives a signal can be implemented.

### 2. The communication chip 200 is used as a driver chip.

In this case, in the communication chip 200, the switch module 203 controls the second interface 205 to form a closed circuit with the third interface 206 through the power division module 202. In other words, the third interface 206, the switch module 203, the power division module 202, and the second interface 205 form a closed circuit, and the switch module 203 is disconnected from the frequency mixer 201 and the first interface 204.

When the second interface 205 needs to send the second input signal, the third interface 206 receives the third input signal. The power division module 202 performs power division on the third input signal to obtain the second input signal, and outputs the second input signal through the second interface 205. In this way, a driver function in the AAU when the base station sends a signal can be implemented.

When the second interface 205 receives the second input signal, the power division module 202 performs combination on the second input signal to obtain the third output signal that needs to be sent by the third interface 206, and outputs the third output signal through the third interface 206. In this way, a driver function in the AAU when the base station receives a signal can be implemented.

In an embodiment of this application, the communication chip includes the frequency mixer, the power division module, and the switch module. The frequency mixer is connected to the first interface, the power division module is connected to the second interface, and the switch module is connected to the third interface. The switch module is configured to control the second interface to form a closed circuit with the third interface through the power division module, so that the communication chip can be used as a driver chip, or to form a closed circuit with the first interface through the power division module and the frequency mixer, so that the communication chip can be used as a frequency mixer chip. In other words, the communication chip has functions of both the frequency mixer chip and the driver chip, and can be separately used as the frequency mixer chip and the driver chip in series at the same time to reduce the loss of the power divider, thereby obtaining the gain brought by antenna array expansion at low costs.

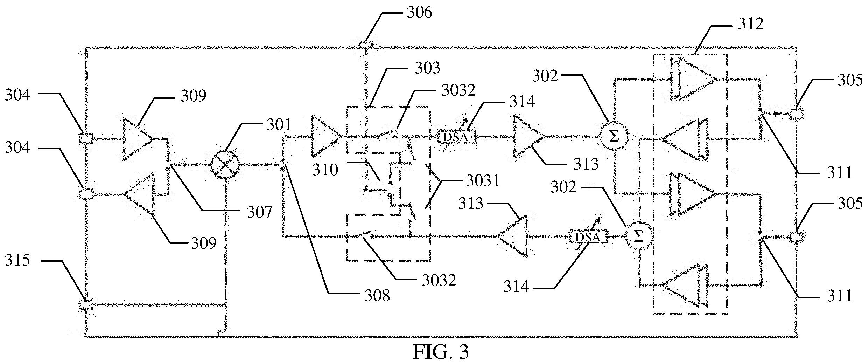

Refer to FIG. 3. Another embodiment of the communication chip in embodiments of this application includes a frequency mixer 301, a power division module 302, a switch module 303, a first interface 304, a second interface 305, a third interface 306, a first signal switch 307, a second signal switch 308, a first amplifier 309, a third signal switch 310, a fourth signal switch 311, a second amplifier 312, a third amplifier 313, and an attenuator 314.

The first signal switch 307 is disposed between the frequency mixer 301 and the first interface 304, and the second signal switch 308 is disposed between the frequency mixer 301 and the switch module 303. The first signal switch 307 and the second signal switch 308 are configured to determine that the first interface 304 is to receive a first input signal or send a first output signal. The first amplifier 309 is disposed between the first signal switch 307 and the first interface 304. The first amplifier 309 is configured to amplify the first input signal or the first output signal. The third signal switch 310 is disposed between the third interface 306 and the switch module 303. The third signal switch 310 is configured to determine that the third interface 306 is to receive a third input signal or send a third output signal. The fourth signal switch 311 is disposed between the second interface 305 and the power division module 302. The fourth signal switch 311 is configured to determine that the second interface 305 is to receive a second input signal or send a second output signal. The second amplifier 312 is disposed between the fourth signal switch 311 and the power division module 302. The second amplifier 312 is configured to amplify the second input signal or the second output signal. The third amplifier 313 is disposed between the power division module 302 and the switch module 303. The third amplifier 313 is configured to amplify the first input signal, the first output signal, the second input signal, the second output signal, the third input signal, or the third output signal. The attenuator 314 is disposed adjacent to the first amplifier 309, the second amplifier 312, or the third amplifier 313.

Specifically, the switch module 303 includes a first channel switch 3031 and a second channel switch 3032. The first channel switch 3031 and the second channel switch 3032 are configured to control the second interface 305 to form a closed circuit with the third interface 306 through the power division module 302, or to form a closed circuit with the first interface 304 through the power division module 302 and the frequency mixer 301. The first amplifier 309 and the third amplifier 313 may be typical amplifiers. The attenuator 314 is of a variable attenuator structure, and may specifically be a digital step attenuator (digital step attenuator, DSA). The second amplifier 312 includes a power amplifier and a low noise amplifier. The communication chip may further include a local oscillator network input pin 315. A plurality of amplifiers and attenuators 314 with same functions may be further disposed in the communication chip. This is not limited in this embodiment of this application.

The communication chip may be used as a frequency mixer chip or a driver chip. The following separately provides descriptions.

### 1. The communication chip is used as a frequency mixer chip.

In this case, in the communication chip, the switch module 303 controls the second interface 305 to form a closed circuit with the first interface 304 through the power division module 302 and the frequency mixer 301. The first channel switch 3031 is open, and the second channel switch 3032 is closed. In other words, the first interface 304, the frequency mixer 301, the switch module 303, the power division module 302, and the second interface 305 form a closed circuit, and the switch module 303 is disconnected from the third interface 306.

When the first interface 304 receives the first input signal, the first signal switch 307, the second signal switch 308, and the fourth signal switch 311 are all in an upward closed circuit. After the first input signal is amplified by the first amplifier 309, the frequency mixer 301 performs frequency conversion on the amplified first input signal, and specifically, may up-convert an intermediate frequency signal to a microwave frequency to obtain the second output signal that needs to be sent by the second interface 305. After the second output signal passes through the attenuator 314 and the third amplifier 313, the power division module 302 performs power division on the second output signal. After being amplified by the second amplifier 312, the second output signal is output through the second interface 305. In this case, the second amplifier 312 is a power amplifier. In this way, a function of the frequency mixer chip in the AAU when the base station transmits a signal can be implemented.

When the first interface 304 needs to send the first output signal, the first signal switch 307, the second signal switch 308, and the fourth signal switch 311 are all in a downward closed circuit. After being input through the second interface 305, the second input signal passes through the second amplifier 312, the attenuator 314, and the third amplifier 313, and is input to the power divider. In this case, the second amplifier 312 is a low noise amplifier. The power divider performs combination on the second input signal to obtain the first output signal that needs to be sent by the first interface 304. The frequency mixer 301 performs frequency conversion on the first output signal, and specifically, may down-convert the microwave signal to the intermediate frequency signal. After passing through the first amplifier 309, the first output signal is output through the first interface 304. In this way, a function of the frequency mixer chip in the AAU when the base station receives the signal can be implemented.

### 2. The communication chip is used as a driver chip.

In this case, in the communication chip, the switch module 303 controls the second interface 305 to form a closed circuit with the third interface 306 through the power division module 302. The first channel switch 3031 is closed, and the second channel switch 3032 is open. In other words, the third interface 306, the switch module 303, the power division module 302, and the second interface 305 form a closed circuit, and the switch module 303 is disconnected from the frequency mixer 301 and the first interface 304.

When the second interface 305 needs to send the second input signal, the second signal switch 308, the third signal switch 310, and the fourth signal switch 311 are all in an upward closed circuit. The third interface 306 receives the third input signal. After the third input signal passes through the attenuator 314 and the third amplifier 313, the power division module 302 performs power division on the third input signal to obtain the second input signal. After being amplified by the second amplifier 312, the second input signal is output through the second interface 305. In this way, a driver function in the AAU when the base station sends a signal can be implemented.

When the second interface 305 receives the second input signal, the second signal switch 308, the third signal switch 310, and the fourth signal switch 311 are all in a downward closed circuit. After the second input signal is amplified by the second amplifier 312, the power division module 302 performs combination on the second input signal to obtain the third output signal that needs to be sent by the third interface 306. The third output signal passes through the attenuator 314 and the third amplifier 313, and is output through the third interface 306. In this way, a driver function in the AAU when the base station receives a signal can be implemented.

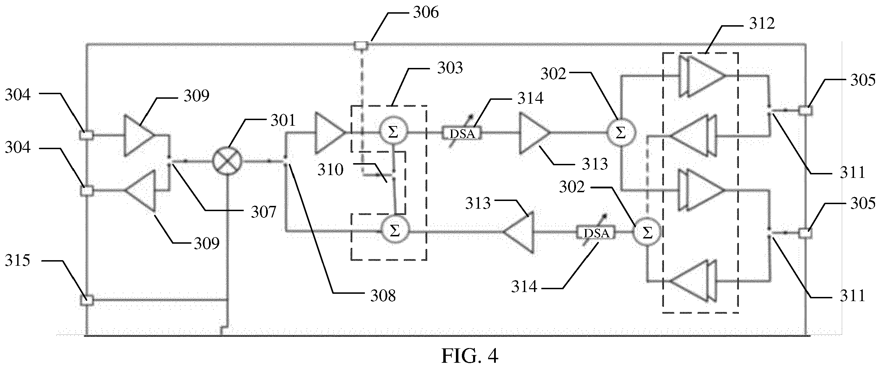

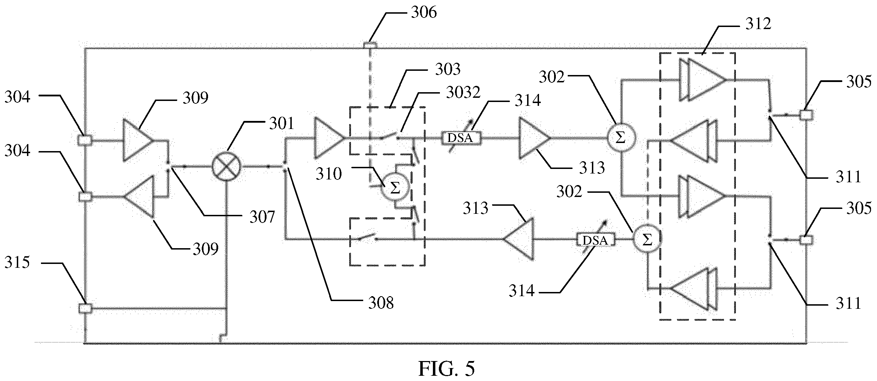

Optionally, the switch module or the third signal switch may be implemented by using a power divider. As shown in FIG. 4, in another embodiment of the communication chip provided in embodiments of this application, the power divider may implement a function and effect of the switch module 303. As shown in FIG. 5, in another embodiment of the communication chip provided in embodiments of this application, the power divider may implement a function and effect of the third signal switch 310.

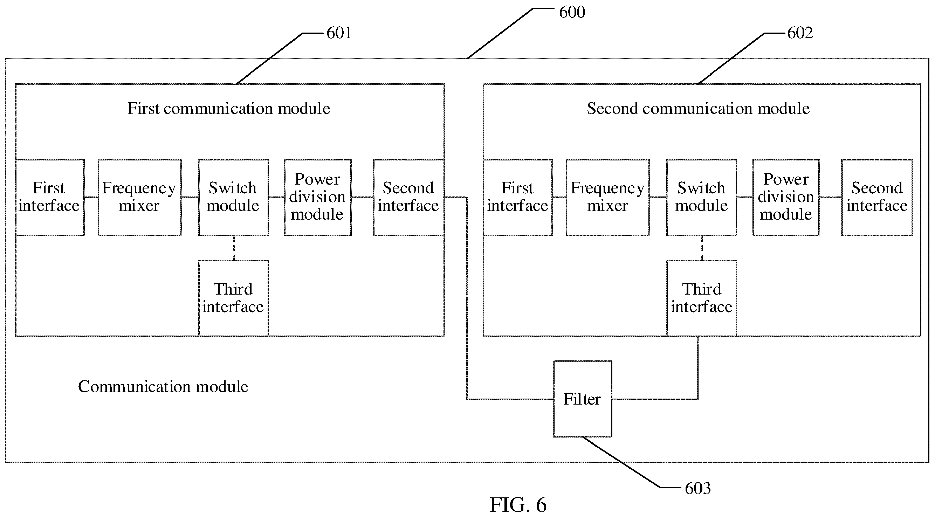

Refer to FIG. 6. An embodiment of a communication module 600 provided in embodiments of this application includes at least two communication chips in the foregoing embodiments, for example, a first communication chip 601 and a second communication chip 602. The switch modules of the at least two communication chips control the second interface to form different closed circuits. To be specific, the first communication chip 601 is used as a frequency mixer chip, and the second communication chip 602 is used as a driver chip. In addition, more communication chips may be disposed as the frequency mixer chip or the driver chip. Optionally, a filter 603 is disposed between the at least two communication chips, that is, a filter may be disposed between the frequency mixer chip and the driver chip.

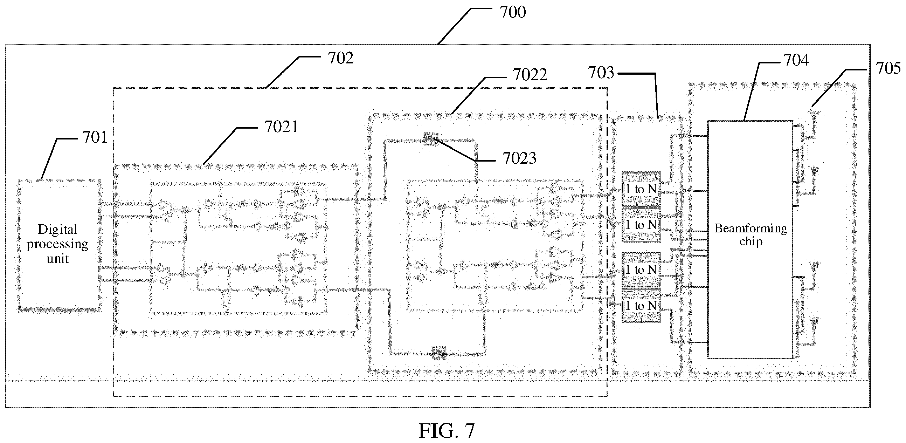

Refer to FIG. 7. An embodiment of a communication system 700 provided in embodiments of this application includes a digital processing unit 701, the communication module 702 in the foregoing embodiments, a multi-way power divider 703, a beamforming chip 704, and an antenna array 705 that are sequentially connected. The communication system 700 is an active antenna unit. The communication module 702 includes a first communication chip 7021 and a second communication chip 7022. A filter 7023 is disposed between the first communication chip 7021 and the second communication chip 7022. The first communication chip 7021 is specifically formed by the two communication chips in the foregoing embodiments, and the two antenna modules are used as frequency mixer chips. The second communication chip 7022 is specifically formed by the two communication chips in the foregoing embodiments, and the two antenna modules are used as driver chips. Optionally, a filter may be further disposed between the communication module 702 and the beamforming chip 704. The digital processing unit 701 may specifically be an ADDA digital processing unit. The beamforming chip 704 may specifically be a beamforming chip (beamforming IC, BFIC) used for a millimeter wave.

In this embodiment of this application, the communication chip in the communication module has both the frequency conversion function and the driver function. This resolves a current problem that a loss caused by passive power division increases when an array in a millimeter-wave system is expanded, and reduces design complexity of the current millimeter-wave system. A millimeter-wave system designed based on this communication chip can simplify a system-level board-level design, where a granularity is small, and no additional local oscillator network is required. By refining the granularity of the communication chip, more communication chips can be used, to increase a quantity of output ports, and reduce constraints on an external power divider. It is assumed that a 1-to-N passive power division network needs to be used in the current technology. When the communication module is used, the power divider may be reduced to 1 -to-N/M, where M depends on integrity of the communication chip, and M may be 1, 2, 4, or the like. This simplifies design of the power division network, and helps obtain a stronger EIRP capability through collaboration.

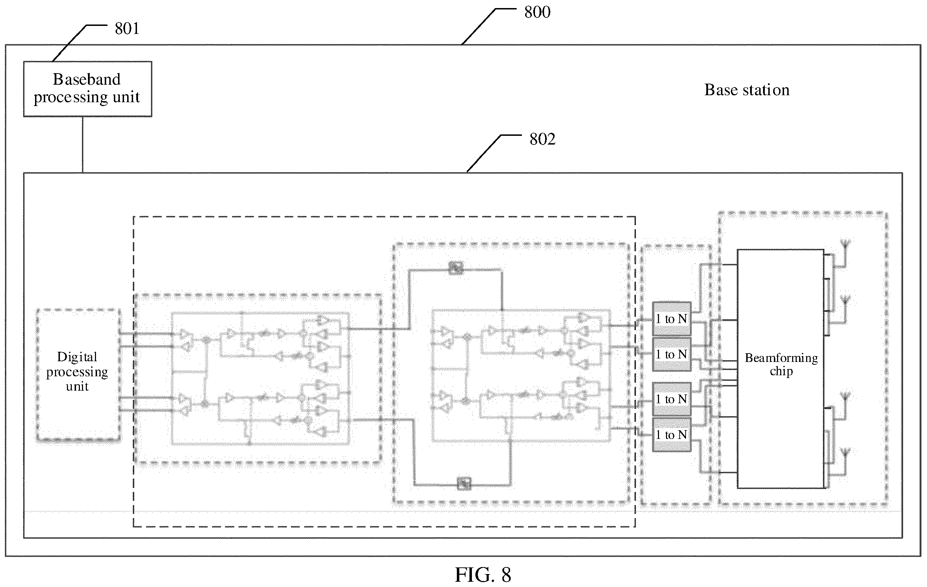

Refer to FIG. 8. An embodiment of a base station 800 provided in embodiments of this application includes a baseband processing unit 801 and the communication system 802 in the foregoing embodiments.

A person skilled in the art may clearly understand that, in several embodiments provided in this application, it should be understood that the disclosed modules, systems, chips, and the like may be implemented in another manner. For example, the module embodiment described above is merely an example. For example, division into the modules is merely division based on logical functions and may be in another division manner during actual implementation. For example, a plurality of modules or interfaces may be combined or integrated into another system, or some features may be ignored or not performed. In addition, the displayed or discussed mutual couplings or direct couplings or communication connections may be implemented through some interfaces. The indirect couplings or communication connections between the modules or systems may be implemented in electronic, mechanical, or other forms.

The modules described as separate parts may or may not be physically separate, and parts displayed as modules may or may not be physical units, that is, may be located in one position, or may be distributed on a plurality of system modules. Some or all the modules may be selected according to actual needs to achieve the objectives of the solutions of embodiments.

## Claims

1. A communication chip, comprising a frequency mixer, a power division module, and a switch module, wherein
the frequency mixer is connected to a first interface, and the frequency mixer is configured to perform frequency conversion on a first input signal received by the first interface or a first output signal that needs to be sent by the first interface;
the power division module is connected to a second interface, and the power division module is configured to perform combination on a second input signal received by the second interface or perform power division on a second output signal that needs to be sent by the second interface; and
the switch module is connected to a third interface, the third interface is configured to receive a third input signal or send a third output signal, and the switch module is configured to control the second interface to form a closed circuit with the third interface through the power division module, or to form a closed circuit with the first interface through the power division module and the frequency mixer.

2. The communication chip according to claim 1, further comprising:
a first signal switch, wherein the first signal switch is disposed between the frequency mixer and the first interface; and
a second signal switch, wherein the second signal switch is disposed between the frequency mixer and the switch module, and the first signal switch and the second signal switch are configured to determine that the first interface is to receive the first input signal or send the first output signal.

3. The communication chip according to claim 2, further comprising:
a first amplifier, wherein the first amplifier is disposed between the first signal switch and the first interface, and the first amplifier is configured to amplify the first input signal or the first output signal.

4. The communication chip according to any one of claims 1 to 3, further comprising:
a third signal switch, wherein the third signal switch is disposed between the third interface and the switch module, and the third signal switch is configured to determine that the third interface is to receive the third input signal or send the third output signal.

5. The communication chip according to any one of claims 1 to 4, further comprising:
a fourth signal switch, wherein the fourth signal switch is disposed between the second interface and the power division module, and the fourth signal switch is configured to determine that the second interface is to receive the second input signal or send the second output signal.

6. The communication chip according to claim 5, further comprising:
a second amplifier, wherein the second amplifier is disposed between the fourth signal switch and the power division module, and the second amplifier is configured to amplify the second input signal or the second output signal.

7. The communication chip according to any one of claims 1 to 6, further comprising:
a third amplifier, disposed between the power division module and the switch module, and the third amplifier is configured to amplify the first input signal, the first output signal, the second input signal, the second output signal, the third input signal, or the third output signal.

8. The communication chip according to claim 7, further comprising:
an attenuator, disposed adjacent to the first amplifier, the second amplifier, or the third amplifier.

9. The communication chip according to any one of claims 1 to 8, wherein the switch module comprises a first channel switch and a second channel switch, and the first channel switch and the second channel switch are configured to control the second interface to form the closed circuit with the third interface through the power division module, or to form the closed circuit with the first interface through the power division module and the frequency mixer.

10. The communication chip according to claim 4, wherein the switch module or the third signal switch is a power divider.

11. A communication module, comprising at least two communication chips according to any one of claims 1 to 10, wherein switch modules of the at least two communication chips control the second interface to form different closed circuits.

12. The communication module according to claim 11, wherein a filter is disposed between the at least two communication chips.

13. A communication system, comprising a digital processing unit, the communication module according to claim 11 or 12, a multi-way power divider, a beamforming chip, and an antenna array that are sequentially connected.

14. The communication system according to claim 13, wherein a filter is disposed between the communication module and the beamforming chip.

15. The communication system according to claim 13 or 14, wherein the communication system is an active antenna unit.

16. A base station, comprising the communication system according to any one of claims 13 to 15.
